# EUROPEAN PATENT APPLICATION

(11) **EP 4 012 744 A1**
(43) Date of publication of application: **15.06.2022**
(21) Application number: 20213255.1
(22) Date of filing: 10.12.2020
(51) Int. Cl.: H01J 37/20

(54) **CHARGED PARTICLE MICROSCOPY MEMS SAMPLE SUPPORT**

(71) Applicant: Universiteit Antwerpen, 2000 Antwerpen (BE)
(72) Inventor: Pedrazo Tardajos, Adrian, 2000 Antwerpen (BE); Bals, Sara, 2000 Antwerpen (BE)
(74) Representative: Jacobs, Tinneke Ivonne C

(57) **Abstract**

The present invention relates to a sample support device (100) for charged particle microscopy. The device comprises a substrate (110) and a heating (101) and/or biasing element (1011) integrated in or on the substrate to heat (or apply a bias voltage to) a sample when positioned in an observation region (102) of the device. The device comprises a membrane (103) covering an opening in the heater element and/or substrate in the observation region (102) of the device. The membrane is perforated to form at least one hole (105) and a graphene layer (104) covers the hole in the membrane to form a sample support to place a sample of interest thereon for study. In a further aspect, the present invention relates to a method of manufacturing such device.

## Description

### Field of the invention

The present invention relates to the field of charged particle microscopy, e.g. transmission electron microscopy, and advanced material engineering, and, more specifically, the invention relates to a charged particle microscopy sample support with an integrated heater and/or biasing electrode(s) and a related manufacturing method.

### Background of the invention

Materials and specimens of interest can be studied by charged particle microscopy, such as transmission electron microscopy (TEM), focused ion beam microscopy. For example, TEM can achieve exceptionally high magnification even with atomic resolution. This enables important insights to be gained about the studied specimen, such as characterizing its crystalline structure and orientation, elemental composition and microstructure, and various further physical properties of interest.

In TEM, an electron beam is focused onto the specimen, and the transmitted beam is measured and quantified to construct an image of the structure of the specimen or to gain elemental and chemical information. However, to hold the specimen in its position, it typically needs to be supported by a sample support grid, of which the signal can interfere with the signal coming from the sample.

The field of transmission electron microscopy (TEM) has significantly evolved in recent years. For example, aberration correctors have improved the attainable resolution, and stability and sensitivity have been drastically improved by novel stages and detector designs. However, significant room for improvement remains in the development of sample holders and supports. The sample support is, ideally, as thin and clean as possible, so the interference with the sample signal obtained from the object under study is limited and known. A sample support grid conventionally comprises a flat surface of a continuous layer, a layer with holes or a mesh. Depending on the sample type, the sample is deposited on the support by a drop-casting procedure, or thin sections of the sample are deposited on the grid via different sample preparation methods. Depending on the nature of the sample, the sample is analyzed on the edge of a hole or on top of a support layer, which allows electrons to pass through.

Conventionally, amorphous carbon-based supports are used, which may typically have a thickness of about 20 nm. However, such sample supports can cause a significant and undesirable background signal, which may be particularly problematic, e.g. for particular types of sample and/or particularly thin samples. A poor manufacturing reproducibility of these supports can furthermore easily lead to failed experiments, or at least a waste of time, resources and/or samples, which might be avoidable if only higher quality supports would be readily available.

Of particular interest are systems that integrate microelectromechanical systems (MEMS), for example for heating, biasing and/or solid-gas (or solid-liquid) interaction experiments. For example, the sample support may be specifically adapted to form a miniature laboratory. A microheater in close proximity to the specimen under study can heat the sample, preferably in a precisely controlled manner. Furthermore, a closed reaction chamber can be formed around the specimen through which a gas (or liquid) can flow to study interactions while imaging the sample. The chamber may, for example, be formed by enclosing the sample between two chips (at least one of which having a suitable cavity formed therein) to isolate it from the external environment.

However, this clearly exacerbates the mentioned problems of conventional supports, since the electron beam in this case has to pass through two surfaces, both of which need to meet high standards so as not to interfere with the obtainable signal quality. Furthermore, the material used to form this chamber is typically silicon nitride (Si₃N₄), which has useful properties, e.g. the ability of a thin membrane of this material to withstand an elevated pressure and high temperature, its use as an electrical insulator and passivation material to protect an integrated heater and its ease of manufacturing in a conventional semiconductor process flow. Thus, MEMS sample holders typically comprise such silicon nitride membranes as electron transparent windows, e.g. on which the sample is deposited. Even if a closed chamber is not required, to integrate a MEMS heater in close proximity to the sample support, this ubiquitous material may still be often used to form a sample support membrane, e.g. in view of its ease of application.

However, these silicon nitride membranes are typically even thicker than conventional carbon supports, and its thermal conductivity and electrical conductivity may be less advantageous for this type of application. For example, charging effects due to the poor electrical conductivity of the silicon nitride windows may hamper the acquisition of high-quality signals in the TEM. Additional distortions in the images can be caused by the thermal expansion of the windows and by so-called bulging effects, in which the height of the window changes due to heating and pressure, causing a loss of focus in the images and enlarging the thickness of the reaction chamber.

For example, EP 2919255 A1 discloses a MEMS-type sample support for confining gases and/or liquids in a sample holder and/or controlling the temperature of the specimen while electron imaging. A membrane region of the device may consist of one or more thin films, which create a physical barrier between the environment in the reaction chamber and the environment within the electron microscope and/or as a support upon which the specimen can be placed.

### Summary of the invention

It is an object of embodiments of the present invention to provide in good, efficient and/or cheap methods of manufacturing a charged particle beam microscopy sample support comprising an integrated MEMS structure (i.e. an integrated heater and/or biasing electrode) and the sample support obtainable thereby.

It is an advantage of embodiments of the present invention that a good, reliable, clean, uniform, and/or homogeneous graphene (mono)layer can be provided onto a charged particle microscopy sample support with an integrated heater and/or electrodes to be used to support and/or enclose the specimen under study.

It is an advantage of embodiments of the present invention that a good (e.g. uniform; continuous; large area) coverage and/or high flatness of the graphene layer can be achieved on such charged particle microscopy sample support.

It is an advantage of embodiments of the present invention that the graphene can be transferred to the charged particle microscopy sample support such as to remain intact or substantially intact.

It is an advantage of embodiments of the present invention that the graphene can be transferred to the charged particle microscopy sample support without or with little contamination, such as contamination by polymers or other organic compounds used in the preparation process.

It is an advantage of embodiments of the present invention that the graphene layer to be used to support the sample in the charged particle microscopy sample support device can have an advantageously low thickness, high thermal conductivity, high electrical conductivity and/or reproducible (good) uniformity.

It is an advantage of embodiments of the present invention that the graphene layer allows a good conduction of heat provided by the integrated heater to the sample, in use of a device in accordance with embodiments.

It is an advantage of embodiments of the present invention that a background signal obtained when imaging a specimen with TEM or related techniques can be advantageously reduced and/or homogenized, thus allowing a simple numerical subtraction.

It is an advantage of embodiments of the present invention that artefacts during charged particle (e.g. electron) microscopy to a non-conductive specimen can be reduced or avoided. This may, for example, enable or improve the study of specimens that are extremely beam sensitive, e.g. including (but not limited to) soft-hard interfaces and/or comprising damage-sensitive (in)organic compounds, e.g. capping ligands.

It is an advantage of embodiments of the present invention that advantageous properties of a conventional sample support membrane, e.g. in terms of structural and temperature stability, such as a silicon nitride membrane, can be combined with the advantageous properties of a graphene monolayer as sample support.

A charged particle microscopy sample support device comprising an integrated heater and/or biasing electrode(s) and a method for manufacturing such device in accordance with embodiments of the present invention achieve the above objective.

In a first aspect, the present invention relates to a sample support device for charged particle microscopy e.g. electron microscopy. The device comprises a substrate and a heater element, and/or a biasing electrode(s), integrated in or on the substrate to heat (resp. and/or to apply a bias voltage to) a sample of interest when positioned in an observation region of the device. The device comprises a membrane covering an opening in the heater element and/or substrate in the observation region of the device. The membrane is perforated to form at least one hole therein (through the membrane). The device further comprises a graphene layer covering the at least one hole in the membrane to form a sample support onto which the sample can be placed for study.

In a sample support device in accordance with embodiments of the present invention, the graphene layer may have a thickness of less than 2 nm.

In a sample support device in accordance with embodiments of the present invention, the membrane may have a thickness in the range of 5 nm to 90 nm.

In a sample support device in accordance with embodiments of the present invention, the membrane may comprise or consists of an amorphous silicon nitride layer.

In a sample support device in accordance with embodiments of the present invention, the at least one hole in the membrane may be at least ten times smaller in diameter than the opening covered by the membrane, which forms the observation region, and/or the at least one hole may have a diameter in the range of 50 nm to 5 µm.

In a sample support device in accordance with embodiments of the present invention, the heater element may comprise a spiral-shaped and/or meandering electrical conductor.

A sample support device in accordance with embodiments of the present invention may comprise at least one heat sink element to improve the temperature stability and/or heating uniformity of a sample when placed on the graphene layer and heated by the heater element.

A sample support device in accordance with embodiments of the present invention may comprise a cap such that a chamber is formed between the cap and the membrane (and the graphene) wherein a sample can be isolated in a controllable (i.e. controlled in use of the device) gaseous or fluid environment.

A sample support device in accordance with embodiments of the present invention may comprise at least one channel to provide a flow of a gas or a fluid of interest through said chamber.

In a second aspect, the present invention relates to a method of manufacturing a sample support device for charged particle microscopy. The method comprises providing a substrate having a heater element and/or a biasing electrode(s) integrated therein or thereon to heat (and/or to apply a bias voltage to) a sample when positioned in an observation region of the device, and comprising a membrane covering an opening in the heater element and/or substrate in the observation region. The method comprises perforating the membrane to form at least one hole through the membrane, and transferring a graphene layer onto the membrane to cover the at least one hole in the membrane such that the graphene layer forms a sample support onto which a sample of interest can be placed for study, in use of the manufactured device.

In a method in accordance with embodiments of the present invention, transferring the graphene layer onto the membrane may comprise:
- obtaining a metal foil onto which the graphene layer is provided,
- stabilizing the graphene layer by applying a layer of a cellulose-based polymer onto the graphene layer,
- placing the metal foil having respectively the graphene layer and the cellulose-based polymer layer stacked thereon in or on an etching solution to dissolve the metal foil supporting the graphene layer,
- diluting and/or neutralizing the etching solution after the metal foil has been dissolved,
- depositing the graphene layer directly onto the membrane by placing the substrate underneath the graphene layer floating in or on the diluted and/or neutralized etching solution and removing the diluted and/or neutralized etching solution until the graphene layer settles onto the membrane to cover said at least one hole, and
- dry cleaning the substrate with the graphene layer deposited on the membrane to remove the cellulose-based polymer layer and contaminants by:
   (a) embedding the substrate with the graphene layer on the membrane in activated carbon and heating the activated carbon, and/or
   (b) applying an annealing treatment in high vacuum.

A method in accordance with embodiments of the present invention may comprise covering the electrodes and/or contact pads with a protective tape or foil, e.g; a polyimide (Kapton) foil, to protect them from the etching solution.

In a method in accordance with embodiments of the present invention, applying the cellulose-based polymer layer may comprise coating the metal foil having the graphene layer attached thereto with a solution of the cellulose-based polymer using a dip-coating method, and removing the cellulose-based polymer that was dip-coated directly onto the metal foil on the side opposite of the side where the graphene layer is provided such that the metal foil is exposed and the graphene layer remains covered by the cellulose-based polymer.

In a method in accordance with embodiments of the present invention, placing the metal foil having respectively the graphene layer and the cellulose-based polymer layer stacked thereon in or on the etching solution may comprise placing the metal foil in or on the etching solution with the metal foil directed downward, such that the graphene layer can settle onto the membrane without inversion in the step of depositing the graphene layer.

A method in accordance with embodiments of the present invention may comprise drying the substrate with the graphene layer deposited on the membrane before the step of dry cleaning.

In a method in accordance with embodiments of the present invention, the activated carbon and the embedded substrate may be heated to a temperature at least 5°C higher than the melting temperature of the cellulose-based polymer and said temperature may be maintained for at least 4 hours.

The independent and dependent claims describe specific and preferred features of the invention. Features of the dependent claims can be combined with features of the independent claims and with features of other dependent claims as deemed appropriate, and not necessarily only as explicitly stated in the claims.

### Brief description of the drawings

FIG 1 shows an illustrative device in accordance with embodiments of the present invention.
FIG 2 shows a transverse cross section of an illustrative device in accordance with embodiments of the present invention.
FIG 3 shows further illustrative devices in accordance with embodiments of the present invention.
FIG 4 shows a yet further illustrative device in accordance with embodiments of the present invention.
FIG 5 shows schematically a transverse cross section of an illustrative device in accordance with embodiments of the present invention that comprises a closed sample chamber.
FIG 6 shows schematically a transverse cross section of another illustrative device in accordance with embodiments of the present invention that comprises a closed sample chamber.
FIG 7 illustrates a method in accordance with embodiments of the present invention.
FIG 8 shows steps of a graphene transfer method that can be applied in a method in accordance with embodiments of the present invention.
FIG 9 illustrates an illustrative approach of placing a graphene layer onto a partially finished device under construction in a manufacturing method in accordance with embodiments of the present invention.

The drawings are schematic and not limiting. Elements in the drawings are not necessarily represented on scale. The present invention is not necessarily limited to the specific embodiments of the present invention as shown in the drawings.

### Detailed description of embodiments

Notwithstanding the exemplary embodiments described hereinbelow, is the present invention only limited by the attached claims. The attached claims are hereby explicitly incorporated in this detailed description, in which each claim, and each combination of claims as allowed for by the dependency structure defined by the claims, forms a separate embodiment of the present invention.

The word "comprise," as used in the claims, is not limited to the features, elements or steps as described thereafter, and does not exclude additional features, elements or steps. This therefore specifies the presence of the mentioned features without excluding a further presence or addition of one or more features.

In this detailed description, various specific details are presented. Embodiments of the present invention can be carried out without these specific details. Furthermore, well-known features, elements and/or steps are not necessarily described in detail for the sake of clarity and conciseness of the present disclosure.

In a first aspect, the present invention relates to a charged particle microscopy sample support device comprising an integrated heater and/or biasing electrode. For example, such sample support device may be used to hold a sample, e.g. a specimen of interest, while being imaged using a charged particle beam, e.g. an electron beam. The sample support device may be a transmission electron microscopy sample support device.

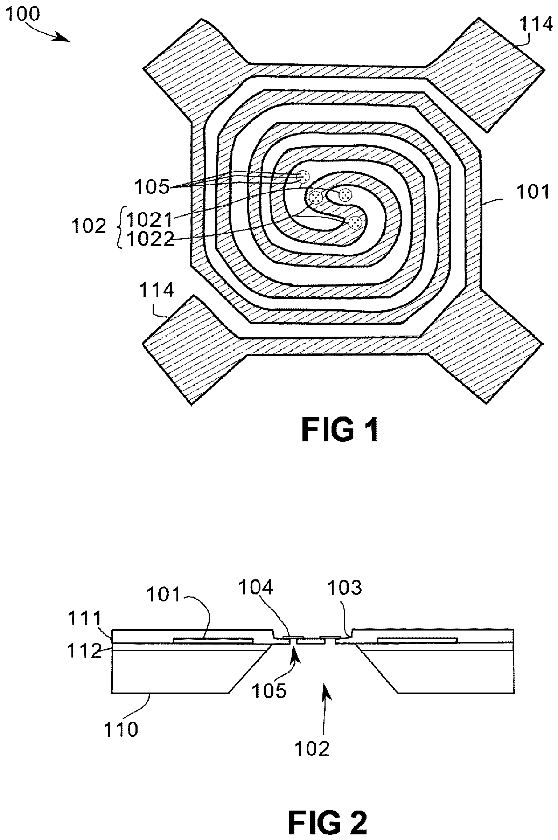

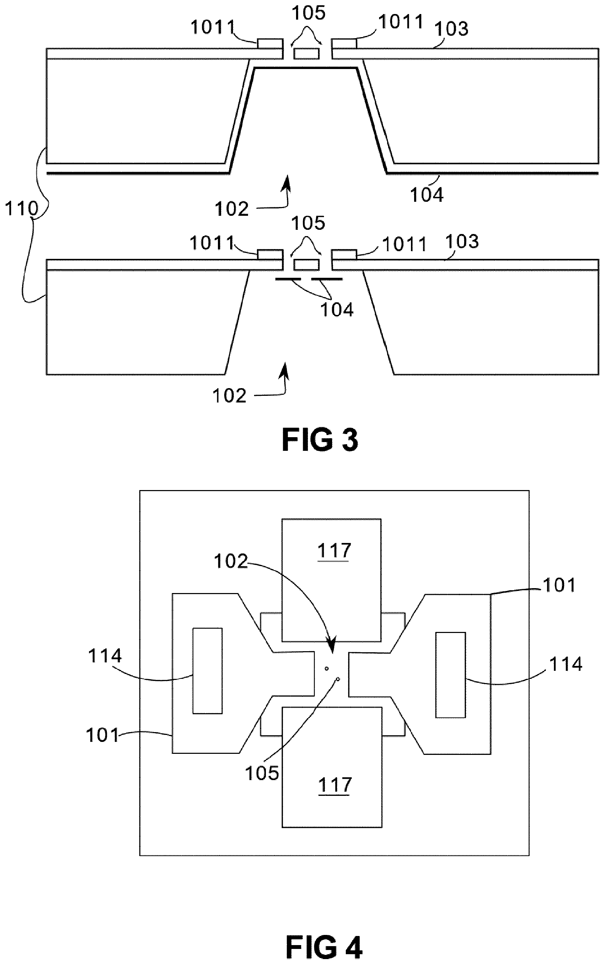

Referring to FIG 1, FIG 2 and FIG 3, an illustrative device 100 in accordance with embodiments of the present invention is shown. The device 100 comprises a MEMS structure, i.e. an integrated heater element 101 and/or biasing electrode(s) 1011. In another example, e.g. as shown in FIG 3, electrodes 1011 may be arranged on (e.g.) opposite sides of an observation region 102, such that a voltage over a sample region in between the electrodes can be controlled via those electrodes 1011. The number of electrodes 1011 may vary, e.g. embodiments may relate to a device comprising three electrodes (e.g. a working, counter and reference electrode), a pair of electrodes, or another variation (of number of electrodes and/or design) as known in the art.

The device 100 may comprise a heater element 101 for heating the sample when positioned in an observation region 102 on the device. The heater element may be adapted to supply heat to the sample by heat conduction and/or ohmic heating. For example, the heater element may comprise an elongate heat and/or electrical conductor, e.g. a metal conductor, between at least two contacts 114, to which heat and/or an electrical current can be applied to heat the sample directly (by heat conduction) or indirectly (by ohmic heating). The (e.g. metal) heater element may comprise a meandering electrical conductor for conducting an electrical current between the at least two contacts to heat the sample. The heater element may have a spiral shape. For example, the metal heater element may be a spiral-shaped microheater, e.g. a double spiral shape. A four-point probe design may be used to allow the temperature to be accurately measured while simultaneously supplying heat via a current.

The heater element may comprise (for example) two counterrotating spiral arms that continuously (e.g. smoothly) transition in a central region, e.g. showing little or no definition or delineation of the central area, but this central region may also be more clearly delineated, e.g. by a broadening of the conductor in the center, e.g. to form a platform-like structure (as generally known in the art).

The observation region(s) is/are not necessarily limited to a central region of the heater, e.g. may be dispersed over the heater (e.g. along its unfolded length) and not necessarily limited to the center or a central part thereof. As shown in FIG 1, the observation region(s) 1022 may be formed directly in (a hole of opening formed in) a principal conductor forming the heater, but the observation region(s) 1021 may also be interspersed in between parts of the conductor (e.g. between folds and/or arms of a meandering and/or spiraling conductor), e.g. formed in an (e.g. insulating) material spacing away different segments of the (e.g. same) conductor. A single device 100 in accordance with embodiments may comprise either one type of observation region 1021, 1022, or a combination of both.

It is also noted that the heater is not necessarily shaped as a spiral or spiral-like structure (even though this may be advantageous to achieve a uniform and fast heating). For example, FIG 4 shows a heater 101 in which a current can be supplied via contacts 114 to run over the observation region 102 to supply heat. If the membrane in the observation region 102 is sufficiently electrically conductive, a current may flow between the heater parts 101. Alternatively, the device schematically depicted in FIG 4 may also be interpreted as showing a pair of biasing electrodes 101 on either side of an electrically insulating membrane.

In the observation region 102, at least one transparent window (e.g. opening or hole) is formed in the heater element 101, in which this window is covered (or formed) by a membrane 103, such as a (e.g. amorphous) silicon nitride layer or a membrane formed from an alternative material, e.g. silicon carbine, boron nitride, carbon, aluminium nitride, silicon dioxide, silicon or any combination thereof. The transparent window is not necessarily provided directly in (i.e. through) the heater element, but may also be disposed in close proximity thereto. For example, FIG 1 illustrates both windows directly in a metal conductor forming the heater 101 and in an insulator material spaced in between the conductive track(s) of the heater.

The membrane may also comprise a stack of different layers, e.g. to optimize its tensile properties. The membrane layer, some layers or all layers may also be doped to obtain suitable characteristics, as is known in the art. Thus, different layers may differ in their material composition, but also (or alternatively) in the type of doping and/or doping levels. To improve the mechanical properties of the membrane, it may be textured or structured, e.g. by locally varying its thickness and/or by forming a pattern of structural support elements, e.g. a grid, in, under or on the membrane. Such structural support elements may be formed by locally thicker parts of the membrane and/or by additional materials formed in the membrane stack, e.g. a thin metal layer.

For example, the observation region 102 may comprise a hole or opening in the heater element (and/or its supporting substrate), such that the membrane 103 extends over (covers) the hole in this observation region. This membrane acts as a sample support, albeit indirectly (the sample can be placed on a graphene layer that is itself supported by the membrane), as well as forms a heatable region, the temperature of which can be (preferably precisely) controlled by the heater element. The membrane allows the sample to be placed in close proximity to this heat source, while enabling a substantially unimpeded transmission of a charged particle (e.g. electron) beam used for imaging the sample (e.g. generally transmitted in a direction perpendicular to the layered structures of the device).

The membrane 103 is also perforated in the observation region 102 to define a hole or holes 105 (i.e. through-hole/s) therein, which are covered by a graphene layer 104, e.g. monolayer of graphene. For example, the hole(s) in the membrane may be at least five, e.g. least ten times smaller in area or in diameter than the hole (in the heater and/or substrate) covered by membrane itself. Note that, for the sake of clarity, the features in the drawings are not necessarily drawn to correspond to actual scale and proportions.

Even though reference is made to the graphene layer 104 "covering" the hole or holes 105, it will be understood that the hole may be covered on either side of the opening, e.g. from a top-side or bottom-side (not strictly excluding a combination thereof either, even though only covering a single side of the hole might be more advantageous). For example, in the examples shown in FIG 3, the graphene is applied to cover the hole or holes from a backside of the substrate (e.g. the side from which the substrate has been etched in these examples to form a cavity in the substrate in the observation region 102). Even though this is shown in combination with a pair of biasing electrodes 1011, it will be understood that embodiments comprising a heater element 101 may equally have the graphene layer 104 applied on the backside (e.g. the substrate-side), or on the frontside (cf. e.g. FIG 2).

For example, the heater element 101 (and/or biasing electrode 1011) may comprise a metal structure formed on a semiconductor, e.g. silicon, substrate 110. The heat element 101 may be formed by depositing a suitable metal layer, such as molybdenum, platinum, gold, copper, etc. (or alloys thereof), (directly or indirectly) onto the substrate 110, and etching this metal layer to define the structure of the heater. The heat element may be covered by an insulating layer 111, or encapsulated between insulating layers 111, 112, of a passivating material, such as silicon nitride, for example such as to form a stack of respectively the substrate 110, the first insulating layer 112, the metal layer 101 and the second insulating layer 111 is formed.

Thus, as generally known in the art, the sample support device may comprise a semiconductor substrate 110, e.g. a (part of a) silicon wafer, e.g. a 400 µm thick single side polished silicon wafer. Onto the substrate 110, a first insulator layer 112 may be deposited, e.g. a 200 nm thick layer of silicon nitride. Onto the first insulator layer 112, a metal layer may be deposited and structured to form the heater element 101, e.g. using a photolithography and reactive ion etching. A second insulator layer 111 may be provided on the heater element 101 for insulation and protection. However, the first insulator layer may be considered to be optional.

In the observation region 102, the second insulator layer 111 may be (optionally) thinned to reduce the thickness of the insulator layer in the observation region. The second insulator layer is not necessarily deposited in a single step. For example, the patterned metal layer may be (entirely) covered by the insulating material, after which one or more windows are etched away (e.g. using again photolithography and RIE), and a thinner layer of the insulating material (the same or a different material) may be provided to cover the window(s) with only this thin layer. Thus, the heater may be insulated by a relatively thick layer (e.g. 400 nm), while the observation window is only covered by a relatively thin layer (e.g. 20 nm). The membrane 103 that covers the window in the heater 101 may thus be formed directly from the (e.g. second) insulator layer 111 covering the heater or may be deposited in a further step as a separate layer after (locally) etching away the aforementioned (second) insulator layer 111. It is to be noted that analogously the membrane may be formed by (e.g. in) a layer underneath the heater. Analogously, referring to FIG 3, a (set of) biasing electrode(s) may be deposited on top of an insulator layer from which the membrane may be formed. Nonetheless, this is only one possible example, and alternative construction methods/designs known in the art for similar MEMS sample support devices may also be applied to embodiments of the present invention.

The substrate and metal layer may be patterned from the backside to define a cavity underneath the window(s), e.g. such that the membrane 103 remains suspended over the cavity, i.e. such that the transparent window(s) in the observation region 102 is formed. A part of the substrate that is not removed may act as a supporting frame to provide structural integrity to the device, e.g. to support the membrane 103 extending over the observation region. For example, the membrane 103 may have a tensile stress profile to keep the membrane taut over the cavity in the substrate in the observation region. The frame may, for example, be formed (at least in part) from the substrate, e.g. by a thick region generally around the perimeter of the device, to provide mechanical support to the device. Thus, the device can be handled without damaging the membrane, and a good contact between the device and a holder can be achieved to use the device in a microscopy system. It may also advantageously provide some thermal isolation of the membrane (and/or between membranes when multiple observation regions are provided).

In the observation region, an opening in the metal heater element 101 is thus covered by the membrane 103, e.g. a silicon nitride Si₃N₄ membrane, which is perforated to form a hole(s) 105 therein. This hole or holes may have a diameter in the range of 50 nm to 5 µm, preferably in the range of 75 nm to 1 µm, e.g. in the range of 100 nm to 500 nm, e.g. in the range of 100 nm to 200 nm. Such perforations may, for example, be formed by a focused ion beam (FIB) process step.

As already mentioned hereinabove, the graphene layer 104 may be provided from above or from below to cover the hole or holes (e.g. w.r.t. the substrate base as 'bottom' layer), for example as illustrated in respectively FIG 2 and FIG 3.

This hole or holes are covered by a graphene layer 104, e.g. a monolayer of graphene. Multiple holes may be covered by a continuous layer of graphene, or each hole may be covered by a separate layer of graphene, e.g. a separate segment of graphene supported by the edges of the hole. It will be understood that covering each hole by a separate piece of graphene (mono)layer may avoid stresses over extended areas of the material, may be easier to manufacture, and may improve the likelihood of obtaining a homogeneous, uniformly thick, unwrinkled and clean surface of graphene covering each hole separately. However, in so far that a piece of graphene layer can be obtained of sufficient dimensions and sufficient quality, the manufacturing process may be more efficient if multiple holes can be covered by a single piece. This concept is schematically illustrated by the two diagrams in FIG 3, in which, in the lower drawing, different segments of graphene are used to cover two (depicted) holes respectively, while in the upper drawing, a single extended, (substantially) continuous piece of graphene covers the holes.

The graphene layer 104 forms a sample support onto which a sample of interest can be deposited for examination by charged particle microscopy, e.g. transmission electron microscopy. The heater element 101 allows the sample to be heated, preferably in a precisely controllable manner (e.g. using a four-point probe method to monitor the temperature during the heating), while being studied. The graphene has, among other advantages, a high thermal conductivity, such that an efficient and uniform heating of the sample can be obtained, while undesired charge effects can be avoided thanks to its high electrical conductivity. On the other hand, the membrane 103 isolates the graphene, and thus also the sample, from an electrical current supplied via the heater and provides a robust support that can also withstand high temperature and/or ambient pressure.

For example, the device may comprise a conventional TEM sample holder with a MEMS technology heater, as known in the art, that is specifically modified to include the perforations covered by graphene. Compared to a (e.g.) copper TEM grid, such MEMS holders may typically comprise at least one silicon nitride membrane (or similar alternative) to form electron-transparent windows onto which the sample can be deposited for analysis. Although such membrane may offer various advantages, such as providing a structurally sound and reliable sample support (even under elevated pressure and/or temperature), it is not ideally suited for high-quality microscopy, since the typical thickness of such membrane can create a substantial background signal, while a poor uniformity of this layer, and thus also of the background signal, may lead to a reduced signal quality and difficulties in performing quantitative measurements. By creating small holes in such membrane and covering these openings with a very thin graphene layer (e.g. a monoatomic graphene layer), advantageous properties of the membrane can be combined with a high-quality electron transmission and heat dissipation achievable by a graphene sample support. Furthermore, as discussed in more detail hereinbelow, the present invention also provides, in a further aspect, a manufacturing process that can provide such graphene sample support elements on the membrane with a very low thickness, e.g. less than (or equal to) 2 nm, a good flatness (e.g. wrinkling is prevented or reduced by the method), a good cleanness and/or a high uniformity.

The device may also comprise other features as known in the art for such MEMS sample holders. For example, heat sink element(s) 117 may be included to improve the temperature stability and/or to obtain a more uniform heating. Such heat sink element may be formed in or on the membrane, or in close proximity thereto. The device may comprise heat sensing element(s), e.g. to enable a measurement of the temperature in, on or near the observation region. As known in the art, such heat sensing element may comprise a thermo-sensitive resistor, thermocouple or thermopile structure. Another example of an optional device feature is a pressure sensor, which may be formed by (e.g.) a metal thin film resistor formed in or on the membrane, to detect a pressure of a gas at the sample location. For example, such pressure sensing element may comprise a metal thin film resistor that undergoes a change in electrical resistance when deformed, such that an ambient pressure can be determined from a measurement of its resistance (or impedance). Other examples include chemical sensing elements to detect specific compounds and/or elements in the local environment where the sample is deposited.

The device may typically also comprise electrical contacts 114, e.g. contact pads, to connect the heater to an electrical power source, and/or to control and/or read sensor signals, which may be created by conventional semiconductor process techniques.

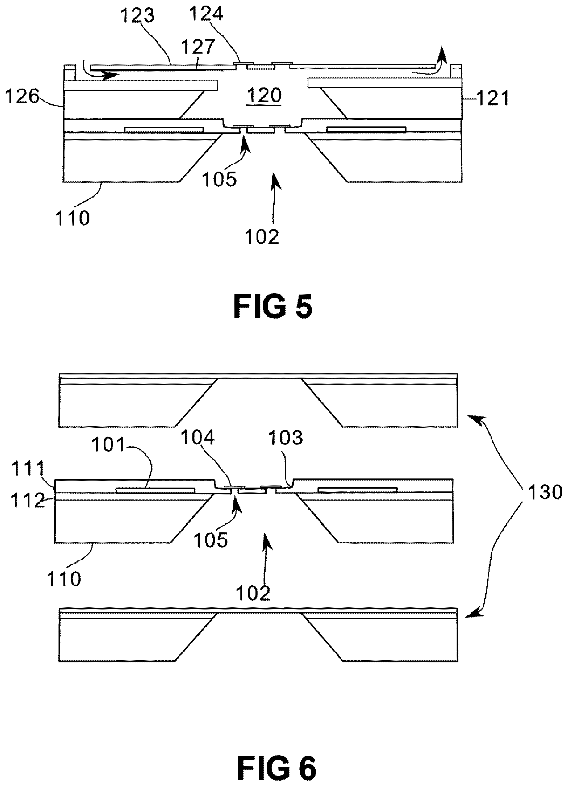

Referring to FIG 5, the device may further comprise a cap 121, e.g. comprising a second substrate 126, to cover at least the membrane, such that a cavity 120 (a chamber) is formed between the cap and the membrane wherein a sample can be isolated in a controllable gaseous or fluid environment. Likewise, this cap may comprise a membrane 123, generally positioned over the same observation region(s), such that an incident beam used for imaging can pass through the sample. This membrane 123 may also be formed by a graphene (mono)layer, or may comprise holes covered by a graphene layer(s) 124, e.g. in generally the same manner as discussed hereinabove. The device may also comprise an O-ring or other type of seal or gasket to fit between the cap 121 and the primary device structure (the device part that is integrated in and/or on the first substrate 110), such as to seal the sample chamber 120.

The device may furthermore comprise at least one channel 127, e.g. microfluidic channels, such that a fluid or gas can be introduced into the chamber, and/or such that a flow of a gas or fluid of interest through the chamber can be provided (e.g. such that the sample can be exposed to the gas or fluid of interest), e.g. as schematically depicted in FIG 5. In other words, at least an inlet and an outlet channel may be defined that connect to the chamber formed between the cap and the membrane. Such channels may be defined in the cap, in the primary substrate (and associated structures) in/on which the heater and membrane are formed, or a combination of both. The term "cap" should not be interpreted too narrowly, since the cap may (or may not) also comprise additional device features, e.g. a heater structure, a sensor element, a heat sink, flow channels, flow regulators, etc.

Likewise, the device does not necessarily comprise a cap, but may be placed in an encapsulating holder, forming a chamber around the device. Such holder may optionally also be provided with an inlet and an outlet to allow a gas (or liquid) to flow through the chamber. This holder may comprise transparent windows, e.g. window devices 130 (see e.g. FIG 6), between which the device holding the sample may be placed to allow a beam to pass through the windows, the device, and the observation region 102 thereof, to image a sample.

In a second aspect, the present invention relates to a method of manufacturing a sample support device for charged particle microscopy, e.g. transmission electron microscopy. For example, the method may be a method of manufacturing a device in accordance with embodiments of the first aspect of the present invention.

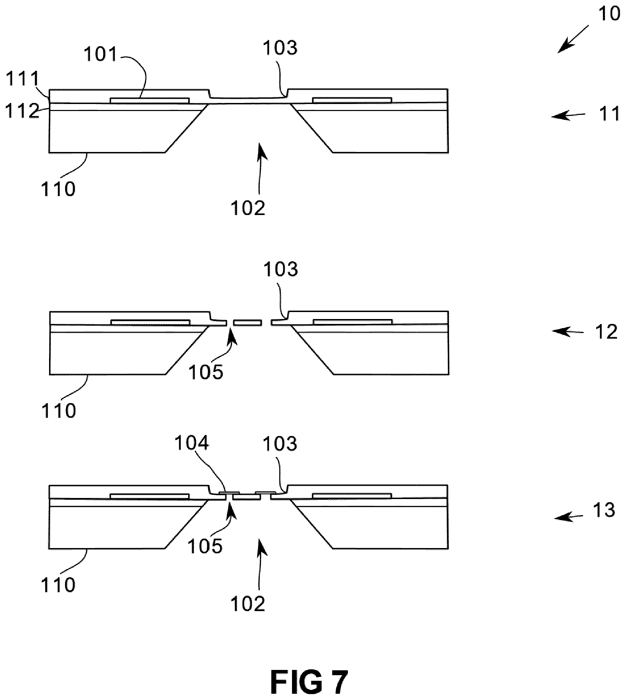

FIG 7 shows an illustrative method 10 in accordance with embodiments of the present invention.

The method 10 comprises providing 11 a substrate 110 having a heater element 101 integrated therein or thereon to heat, in use of the device, a sample when positioned in an observation region 102 of the device, and in which a membrane 103, e.g. a silicon nitride membrane, covers an opening in the heater element and/or substrate in an observation region 102 thereof.

This step of providing 11 the substrate and associated structures may comprise obtaining a MEMS sample support device as presently commercially available, or the manufacturing of such device in accordance with methods known in the art. For example, the heater element 101 may be formed from a metal layer deposited on a suitable semiconductor substrate, e.g. a silicon wafer. The metal layer (or stack of layers) may be patterned to define the heater structure. The heater element may be encapsulated between two insulator layers 111, 112, or covered by an insulator layer 111. In the observation region 102, the insulator layer 111 may be thinned to form the membrane, or locally removed to subsequently deposit a separate layer to form the membrane. The substrate and metal layer may be patterned from the backside to define a cavity underneath the membrane in the observation region, e.g. such that the membrane remains suspended over the cavity.

The method 1 comprises perforating 12 the membrane 103 to form at least one (through)hole 105 therein. For example, this hole or holes may have a diameter in the range of 50 nm to 5 µm, preferably in the range of 75 nm to 1 µm, e.g. in the range of 100 nm to 500 nm, e.g. in the range of 100 nm to 300 nm. Perforating 12 the membrane may comprise creating the hole(s) by a focused ion beam (FIB), e.g. using FIB SEM. For example, a Ga source may be used to generate the FIB beam, e.g. at 30 kV and 80 pA. The hole or individual holes may (e.g.) be dimensioned according to (about) 10% of the average grain size of the graphene of the graphene layer 104 to be transferred on the membrane (e.g. which may have a grain size of about 2 µm). An array of holes may be provided, e.g. a periodic array, or a single hole in the membrane. For example, a low number or only one hole may be preferable in embodiments where a substantially sealed chamber 120 is to be achieved (e.g. as discussed hereinabove), e.g. to prevent leakage of gases and/or fluids from the chamber.

Optionally, the method may comprise a treatment of the unfinished device (i.e. before transferring 13 the graphene layer) with a plasma cleaning, e.g. using argon and/or oxygen plasma, to increase the hydrophilicity of the surface onto which the graphene layer is to be transferred. As an example, a Fishione Model 1070 plasma cleaner may be used for an Ar/O₂ plasma cleaning of 30 seconds at 30 sccm and 15 Watt (other settings, equipment and/or plasma treatment methods not excluded).

Furthermore, the method may comprise protecting contacts (e.g. contact pads 114) of the unfinished device, e.g. using a (easily) removable coating or protective tape. For example, Kapton tape or a similar tape for sensitive materials (and that can withstand high temperatures) may be used. This step may be carried out before the step of transferring 13 the graphene layer, or specifically before a dry cleaning 31 step thereof, discussed in detail hereinbelow, to protect the contacts during a heat treatment in said step.

The method comprises transferring 13 a graphene layer 104 onto the membrane 103 to cover the at least one hole through the membrane to form a sample support onto which a sample of interest can be placed for study, e.g. for microscopy imaging.

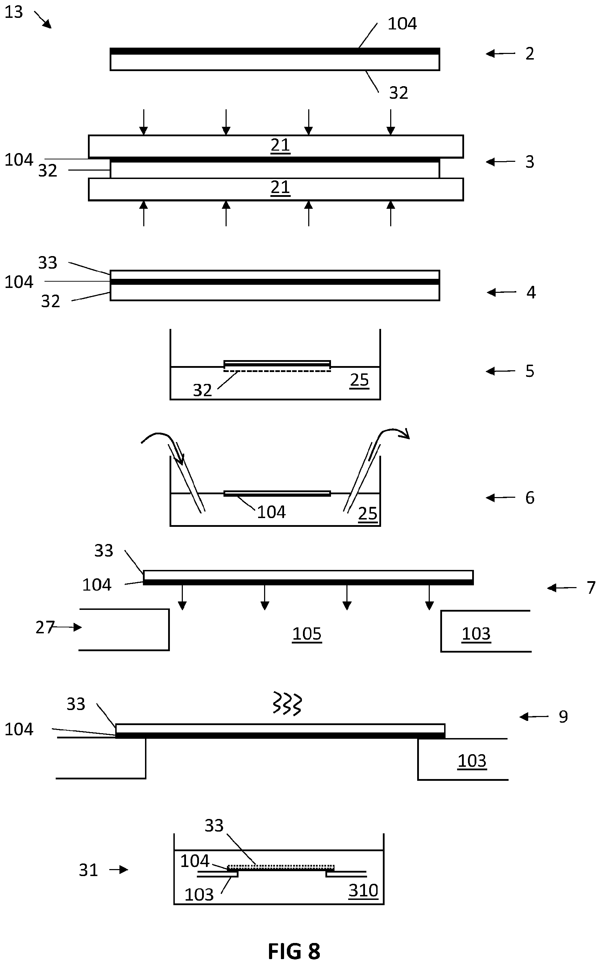

Transferring 13 the graphene layer, e.g. a graphene monolayer, onto the membrane 103 may comprise a transfer method as illustrated in FIG 8. By this transfer method, advantageously a low graphene roughness and a good flatness can be achieved, e.g. avoiding or reducing wrinkles of the layer.

Transferring 13 the graphene layer may comprise obtaining 2 a metal foil 32 onto which the graphene (mono)layer 104 is provided. The graphene layer 104 may be a monolayer, e.g. having large single-crystalline domains. The graphene layer 104 may be grown by chemical vapor deposition (CVD) onto the metal foil 32, e.g. as known in the art.

For example, the metal foil with graphene layer may be a monolayer CVD graphene on copper (Cu), which is for example commercially available from Graphenea Inc., Cambridge (USA). The same or similar product may be available from other high-quality graphene providers for research and/or high-tech applications. For example, such graphene foils may be available in a size of about 1 cm2 or more, e.g. 15 cm by 15 cm, e.g. 10 mm by 10 mm.

Obtaining 2 the metal foil with the graphene (mono)layer thereon may comprise forming a graphene layer (e.g. monolayer) on a metal foil, e.g. using chemical vapor deposition. Many variations are known in the art to synthesize a graphene layer onto a metal substrate, e.g. using CVD. For example, methane gas can be used as carbon source for such deposition process, and alternatives may include e.g. petroleum asphalt. Hydrogen may be used in the process to promote carbon deposition (e.g. using a combination of methane and hydrogen at a suitably tuned flow ratio). The hydrogen may advantageously corrode amorphous carbon and improve the quality of the deposited graphene, but should be used in moderation to avoid corrosion of the graphene and/or damage to the formed crystal lattice. The carrier gas may comprise an inert gas, e.g. argon, for example in combination with hydrogen. Optionally, a catalyst may be used, such as iron nanoparticles, nickel foam and/or gallium vapor. Not only the gas flow ratio is typically tuned to optimize results, but also the ambient pressure, temperature and chamber material may need to be considered to achieve high-quality layers. Quartz may be a suitable material for the CVD chamber and auxiliary tubing. These deposition processes are well-known in the art, and the skilled person is capable of determining such parameters with straightforward experimentation and the knowledge readily available in the field.

Transferring 13 the graphene layer may comprise mechanically flattening 3 the metal foil 32 (supporting the graphene layer 104), e.g. by compressing the foil (with graphene layer) between two flat surfaces 21. For example (without limitation thereto), the metal foil may be placed between two clean microscope slides, e.g. previously cleaned with ethanol and acetone to avoid contamination of the graphene layer 104.

Transferring 13 the graphene may comprise stabilizing the graphene layer 104 by applying 4 a layer 33 of a cellulose-based polymer, e.g. cellulose acetate butyrate (CAB), onto the graphene layer 104. Other examples of cellulose-based polymers may include ethyl cellulose (EC), cellulose acetate (CA) and cellulose acetate propionate (CAPr). Other examples may comprise, for example, formvar (polyvinyl formal), butvar (polyvinyl butyral resin) and/or glycol, without limitation of embodiments to the mentioned examples.

The layer 33 may be a thin layer, e.g. having a thickness in the range of 10 nm to 500 µm, preferably in the range of 15 nm to 1µm, e.g. in the range of 15 nm to 100 nm, e.g. about 20 nm. For most purposes, a layer of 20 nm may be considered sufficient, even though higher values are not necessarily detrimental. However, the final step of cleaning away the cellulose-based polymer may be easier, faster and/or less prone to leaving contamination behind when a layer thickness in the lower ranges mentioned hereinabove is selected.

The step of applying the cellulose-based polymer layer onto the graphene layer may comprise coating the metal foil having the graphene layer attached thereto with a solution of the cellulose-based polymer, e.g. using a dip-coating method.

For example, the metal foil with graphene may be dip-coated with a coating solution, e.g. a solution of 0.25 g CAB (e.g. having an average molecular weight Mₙ of about 30000; e.g. as commercially available from Merck KGgA; CAS no. 9004-36-8) in 100 mL ethyl acetate or another suitable solvent (e.g. a solution of 2.5 g/L CAB in ethyl acetate). Other suitable cellulose-based polymer solutions, e.g. preferably in a suitable volatile solvent, may be considered as well. Obviously, a homogenous solution can be achieved by stirring or another type of agitation, e.g. using a magnetic stirrer. The solution of CAB may have a concentration in the range of 1 g/L to 10 g/L, e.g. in the range of 1.5 g/L to 5 g/L, e.g. in the range of 2 g/L to 3 g/L, e.g. in the range of 2.3 g/L to 2.7 g/L of CAB in ethyl acetate or another suitable solvent. The CAB may have a molecular weight (Mn) in the range of 12*10^{∧}3 to 70*10^{∧}3, e.g. 12*10^{∧}3, e.g. 30*10^{∧}3, e.g. 70*10^{∧}3.

For example, in such dip-coating process to apply 4 the layer 33 of the cellulose-based polymer onto the graphene layer, the metal foil 32 with graphene layer 104 may be immersed in the coating solution, e.g. at a substantially constant (i.e. jitter-free) speed. After a predetermined time in the solution, the substrate is pulled out of the solution such that a thin layer of the cellulose-based polymer deposits on the substrate during the pull-up. Again this pulling up may be carried out, preferably, at a constant (jitter-free) speed. This speed can be tuned to determine the thickness of the coating, and/or the immersion process can be repeated (one or more times) to achieve a desired layer thickness. Excess liquid may then be drained from the surface, and the solvent (e.g. ethyl acetate) can be allowed to evaporate, thus forming the thin layer. The layer of the cellulose-based polymer may be applied such as to reach a layer thickness (of the cellulose-based polymer) in the range of 10 nm to 100 nm, preferably in the range of 15 nm to 30 nm, e.g. about 20 nm. It is an advantage of a dip-coating that the thickness of the layer can be easily and reproducibly controlled in this range, e.g. to achieve a layer thickness of about 20 nm.

The cellulose-based polymer, e.g. CAB, on the side of the metal foil 32 that is opposite of the side covered by the graphene layer 104 may then be removed from the metal foil, e.g. by a suitable solvent such as acetone. For example, dip-coating may produce a stack of CAB-graphene-Cu-CAB, wherein the CAB layer directly on the metal foil is removed to obtain substantially a stack of CAB-graphene-Cu. For example, the CAB (on the side where it is not desirable) may be removed using a drop of acetone, which is applied carefully to the side to be cleaned to avoid spreading to the topside of the CAB-graphene-Cu stack. A drop of acetone may be deposited on a clean surface, e.g. a glass slide, and the backside of the stack may be brought carefully into contact with the acetone with due care to avoid dispersion to the other side.

Thus, the graphene layer to be stabilized and protected is covered by a cellulose-based polymer layer, while the other side of the metal foil is substantially cleaned of this polymer, such that it can be exposed to an etchant.

The step of transferring the graphene may further comprise placing 5 the metal foil 32, having respectively the graphene layer 104 (directly) and the cellulose-based polymer layer 33 (indirectly) provided on top thereof, in or on an etching solution 25 to dissolve the metal 32 supporting the graphene layer 104. For example, the metal foil 32 may be placed downside onto the surface of the etching solution to further avoid or minimize damage to the sensitive graphene layer, e.g. allowing the foil to float in or preferably on the etching solution.

The etching solution 25 may comprise ammonium persulfate ((NH₄)₂S₂O₈) or may consist of a solution of ammonium persulfate, e.g. in (substantially pure) water. It is an advantage that, thanks to the stabilization by the polymer, a relatively high concentration, e.g. 3.4%, of ammonium persulfate can be used, which thus contributes to a speedy process. This also has the advantage that the graphene is protected from damage and/or wrinkling.

For example, the dissolution of the metal foil can be carried out in less than 4 hours, e.g. less than 2 hours, e.g. about an hour or even less. Even though the etching time may, generally, depend on the concentration of the etching solution, the stabilizing effect of the cellulose-based polymer enables the use of a relatively high concentration, and thus a rapid etching.

For example, the etching solution 25, e.g. an ammonium persulfate solution, may be heated to a temperature in the range of 30° to 50°C, e.g. in the range of 35°C to 45°C, e.g. about 40°C, e.g. to further increase the efficiency of the chemical etching process. For example, the solution may be prepared on a hotplate (e.g. at 40°C) while preferably being continuously stirred, e.g. using a magnetic stirrer (e.g. at 650 rpm). However, it is to be noted that heating the etching solution is not necessarily required, e.g. the same etching can be achieved at room temperature, even though a faster etching can be achieved at elevated temperature.

The etching solution may be a solution of ammonium persulfate of 3.42 g in 100 mL (e.g. 34.2g/L) in a suitable solvent, preferably water, and even more preferably ultrapure water (UPW), e.g. according to the standards defined in ASTM D5127 and/or SEMI F63. The concentration of the ammonium persulfate may be in the range of 0.3 g to 5 g per 100 mL solvent, e.g. in the range of 0.3 g to 4 g per 100 mL solvent, e.g. in the range of 2 g to 4 g per 100 mL solvent, e.g. in the range of 3.0 g to 3.5 g per 100 mL solvent, e.g. in the range of 3.3 g to 3.4 g per 100 mL solvent. While excessive etching concentrations could potentially damage the graphene, it is noted that higher concentrations may fasten the etching process considerably. However, if the exposure time is adjusted accordingly, a copper foil can be etched away with concentrations of etchant ((NH₄)₂S₂O₈) as low as, e.g., 0.34 g/100 mL UPW.

In order to prevent contamination by the dissolved metal of the metal foil, the graphene transfer process may comprise diluting and/or neutralizing 6 the etching solution 25 before removing the graphene layer, which is now only attached to (and stabilized by) the remaining cellulose-based polymer layer 33. For example, this dilution may comprise a gradual dilution (and/or neutralization) using water, e.g. ultrapure water, to remove the metal, e.g. copper, residues. For example, clean solvent, e.g. ultrapure water, may be added repeatedly, e.g. while siphoning off excess solution (e.g. using a pipette).

The etching solvent may thus be removed by exchanging it, e.g. in steps, with water (preferably UPW), for example until the pH has reached a value sufficiently close to pure water, e.g. in the range of 6.9 to 7.1 or substantially 7.0. For example, the etching solvent may be exchanged with water repeatedly until the pH value is increased from an acid environment (e.g. about 3) to neutral (e.g. about 7).

This step avoids damage to the target substrate, i.e. the membrane onto which the graphene is transferred, and may prevent or reduce contamination by residues of the dissolved metal.

While the etching solvent may be alternatively exchanged with another solvent, such as isopropanol and/or acetone, experiments have shown that these alternatives could potentially lead to a higher contamination and/or could pose problems, e.g. of the graphene tending to attach more easily to the wall of the recipient. Nonetheless, embodiments using another solvent than water for dilution and/or exchange of the etching solution are not necessarily excluded.

The graphene transfer step may further comprise depositing 7 the graphene layer 104 (directly) onto the membrane 103 to cover the at least one hole 105 through the membrane. It is an advantage of a method in accordance with embodiments that the graphene layer, floating in or on the diluted etching solution, can be easily scooped onto the target substrate or structure.

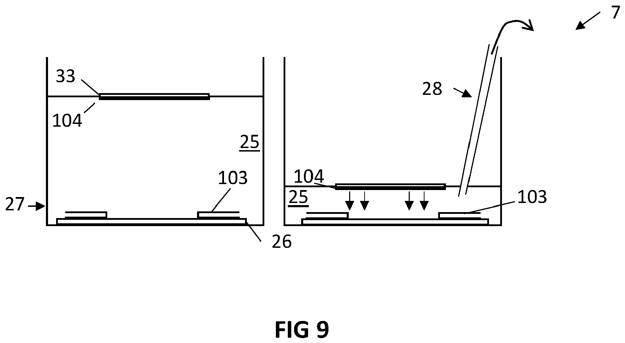

Referring to FIG 9, depositing 7 the graphene layer onto the target membrane may comprise placing 27 the target substrate with the perforated membrane underneath the graphene layer floating in the solution 25, e.g. the diluted and/or neutralized etching solution 25 (e.g. substantially exchanged by the solvent, preferably water, even more preferred UPW), and removing 28 the solution until the graphene layer settles over the perforation hole and (along its edges) onto the membrane 103. For example, the solution may be removed by a (e.g. microliter) pipette, or another suitable method, such as by a pump or by evaporation (or any combination thereof).

The target substrate with the perforated membrane may, for example, be placed 27 on top of a piece of filter paper 26 or other suitable protective (e.g. shock absorbing) material at the bottom of the recipient containing the solution 25, and the graphene layer 104 can thus be softly lowered on top of the substrate or structure by gently removing the solution without risk (or with reduced risk) of damage. It will also be appreciated that such filter paper 26 or similar carrier material can be used to easily manipulate the substrate or structure, e.g. to remove the construct from the recipient once the graphene layer has been deposited thereon. Furthermore, the filter paper 26 may be provided with a film, e.g. a parafilm, to attach the target substrate onto the filter paper (i.e. preventing the target substrate from floating in the solution). Alternatively, such film may be applied directly to the (bottom of) the recipient to temporarily attach the target substrate while the graphene is deposited onto the target location on the membrane.

Even though reference is made to the 'solution' for the sake of clarity, it will be understood that the 'solution' at this stage in the process may be substantially nothing more than water, e.g. if the aforementioned step of removing 6 (by diluting and/or neutralizing) the etching solvent was carried out effectively.

It will also be understood that the position of the graphene layer, while lowering it on top of the substrate or structure can be controlled during this step, e.g. by gentle nudges and/or by controlling the (direction of the) flow by which the solution is being removed, such that a good alignment of the graphene layer on the target (hole in the membrane) can be obtained.

The graphene transfer step may further comprise drying 9 the target substrate with the graphene layer 104 deposited over the hole(s) in the membrane. For example, by placing the construct on a hotplate, e.g. at a temperature in the range of 25°C to 50°C, e.g. in the range of 30°C to 40°C, e.g. about 35°C. For example, about one hour may suffice to dry the device (without limitation thereto). It is to be noted that, when placed on a filter paper or other suitable carrier material, it is not only easy to remove the construct from the recipient that contained the diluted etching solution (e.g. substantially water) for drying, but that the construct may also be protected from direct heat in the drying process. It is also noted that the drying may also be carried out in situ, e.g. without removing from the recipient, to avoid any damage due to manipulation.

The transfer step may further comprise a dry cleaning 31 (a dry heating treatment) to remove the cellulose-based polymer layer 33.

In this step, the construct (i.e. the substrate with the graphene layer 104 placed on the membrane and the remaining cellulose-based polymer 33 on the graphene) may be embedded in activated carbon 310. For example, the activated carbon may be provided in a recipient (e.g. a petri dish) or pile, a pit may be formed in the activated carbon, and the construct may be buried in this pit, substantially covering the construct from all sides by the activated carbon (i.e. closing the pit). For example, a heap of 0.7 cm activated carbon may be provided, and the construct may be buried at a depth of about 0.5 cm in this heap.

The activated carbon 310 in which the construct is embedded may then be heated, e.g. to a temperature in the range of 200°C to 350°C, e.g. in the range of 250°C to 300°C, for example at a rate of 5°C per minute. Specifically, the target temperature is higher than the melting temperature of the cellulose-based polymer, but conservatively selected to avoid damage to the graphene and/or the target substrate or structure (e.g. the membrane). For example, the target temperature may be at least 5°C, preferably at least 10°C, above (an upper limit of) the melting temperature. This heat treatment may be carried out in a vacuum chamber.

This target temperate is maintained for a sufficient time, e.g. at least 4 hours, e.g. at least 8 hours, e.g. for a time in the range of 10 hours to 24 hours, e.g. 15 hours. After cooling down (and removing of the construct from the carbon, or vice versa), the sample support device remains, with the graphene layer positioned over the perforated membrane, while the polymer is cleaned away.

By heating in activated carbon, e.g. for 15h at 300°C, the cellulose-based polymer, e.g. CAB, and potentially other contaminants can be efficiently removed. The melting temperature of CAB is between 170°C and 240°C, such that a temperature slightly above the melting temperature of the polymer can liquify the material and allow it to be absorbed by the carbon. It is to be noted that other cellulose-based polymers may equally be suitable for a method in accordance with embodiments, and the temperature of the thermal treatment can be adjusted accordingly.

Alternatively, (or additionally) the step of dry cleaning 31 to remove the cellulose-based polymer layer 33 and possible contaminants may comprise an annealing treatment in vacuum (e.g. a high vacuum).

The method may also comprise a rapid cooling of the activated carbon with the device therein embedded, after this heat treatment step, e.g. by exposure to liquid nitrogen, e.g. to avoid degassing.

The contacts of the device may be protected during this step by a protective coating or tape, as discussed hereinabove. Such protective tape or coating may subsequently be removed.

## Claims

1. A sample support device (100) for charged particle microscopy, the device comprising:
- a substrate (110),
- a heater element (101) and/or biasing electrode (1011) integrated in or on the substrate to heat and/or bias a sample of interest when positioned in an observation region (102) of the device,
- a membrane (103) covering an opening in the heater element and/or substrate in the observation region (102) of the device, wherein said membrane is perforated to form at least one hole (105) therein, and
- a graphene layer (104) covering said at least one hole in said membrane to form a sample support to place the sample thereon for study.

2. The sample support device of claim 1, wherein said graphene layer (104) has a thickness of less than 2 nm.

3. The sample support device of claim 1 or claim 2, wherein said membrane (103) has a thickness in the range of 2 nm to 1 µm.

4. The sample support device of any of the previous claims, wherein said membrane (103) comprises or consists of an amorphous silicon nitride layer.

5. The sample support device of any of the previous claims, wherein said at least one hole (105) in said membrane (103) is at least ten times smaller in diameter than said opening, covered by said membrane, forming the observation region (102), and/or wherein said at least one hole (105) has a diameter in the range of 50 nm to 5 µm.

6. The sample support device of any of the previous claims, wherein said heater element (101) comprises a spiral-shaped and/or meandering electrical conductor.

7. The sample support device of any of the previous claims, comprising at least one heat sink element (117) to improve the temperature stability and/or heating uniformity of a sample when placed on the graphene layer (104) and heated by the heater element (101).

8. The sample support device of any of the previous claims, comprising a cap (121) to cover at least the membrane such that a chamber (120) is formed between the cap and the membrane wherein a sample can be isolated in a controllable gaseous or fluid environment.

9. The sample support device of claim 8, comprising at least one channel (127) to provide a flow of a gas or a fluid of interest through said chamber (120).

10. A method (10) of manufacturing a sample support device (100) for charged particle microscopy, the method comprising:
- providing (11) a substrate (110) having a heater element (101) and/or biasing electrode (1011) integrated therein or thereon to heat and/or bias a sample when positioned in an observation region (102) of the device, and comprising a membrane (103) covering an opening in the heater element and/or the biasing electrode and/or the substrate in said observation region (102),
- perforating (12) said membrane to form at least one hole (105) through the membrane, and
- transferring (13) a graphene layer (104) onto said membrane to cover said at least one hole in said membrane such that the graphene layer forms a sample support onto which a sample of interest can be placed for study.

11. The method of claim 10, wherein transferring (13) the graphene layer (104) onto the membrane (103) comprises:
- obtaining (2) a metal foil (32) onto which the graphene layer (104) is provided,
- stabilizing the graphene layer by applying (4) a layer (33) of a cellulose-based polymer onto the graphene layer (104),
- placing (5) the metal foil (32) having respectively the graphene layer (104) and the cellulose-based polymer layer (33) stacked thereon in or on an etching solution (25) to dissolve the metal foil (32) supporting the graphene layer (104),
- diluting and/or neutralizing (6) the etching solution (25) after the metal foil (32) has been dissolved,
- depositing (7) the graphene layer (104) directly onto the membrane (103) by placing (27) the substrate (110) underneath the graphene layer floating in or on the diluted and/or neutralized etching solution (25) and removing (28) the diluted and/or neutralized etching solution until the graphene layer settles onto the membrane to cover said at least one hole, and
- dry cleaning (31) the substrate (110) with the graphene layer (104) deposited on the membrane (103) to remove the cellulose-based polymer layer (33) by:
∘ embedding the substrate (110) with the graphene layer (104) on the membrane (103) in activated carbon (310) and heating the embedded substrate in the activated carbon, and/or
∘ applying an annealing treatment in vacuum.

12. The method of claim 11, wherein the activated carbon (310) and the embedded substrate are heated to a temperature at least 5°C higher than the melting temperature of the cellulose-based polymer and said temperature is maintained for at least 4 hours.

13. The method of claim 11 or claim 12, comprising drying (9) the substrate (110) with the graphene layer (104) deposited on the membrane (103) before said step of dry cleaning (31).

14. The method of any of the claims 11 to 13, wherein placing (5) said metal foil (32) having respectively the graphene layer (104) and the cellulose-based polymer layer (33) stacked thereon in or on the etching solution (25) comprises placing the metal foil (32) in or on the etching solution with the metal foil directed downward, such that the graphene layer (104) can settle onto the membrane (103) without inversion in the step of depositing (7) the graphene layer.

15. The method of any of the claims 11 to 14, wherein applying (4) said cellulose-based polymer layer (33) comprises coating the metal foil (32) having the graphene layer (104) attached thereto with a solution (23) of the cellulose-based polymer using a dip-coating method, and removing the cellulose-based polymer that was dip-coated directly onto the metal foil (32) on the side opposite of the side where the graphene layer (104) is provided such that the metal foil is exposed and the graphene layer (104) remains covered by the cellulose-based polymer (33).
